# EUROPEAN PATENT APPLICATION

(11) **EP 2 314 733 A1**
(43) Date of publication of application: **27.04.2011**
(21) Application number: 10179582.1
(22) Date of filing: 13.11.2002
(51) Int. Cl.: C23C 14/34, C23C 14/35, C23C 14/56

(54) **Apparatus**

(30) Priority: 13.11.2001 GB 0127251
(62) Divisional of application: 02777536.0
(71) Applicant: Nordiko Technical Services Limited, Havant Hampshire, PO9 1QU (GB)
(72) Inventor: Davis, Mervyn Howard, West Sussex, PO20 7HB (GB)
(74) Representative: Smaggasgale, Gillian Helen

(57) **Abstract**

A vacuum sputterring apparatus capable of depositing a plurality of thin film layers on a substrate, the apparatus comprising: a vacuum chamber (1) having gas inlet means and gas evacuation means; a substrate support table (2) arranged to be rotatable about at least one axis perpendicular to the plane of the table; means for rotating the substrate support table about said at least one axis; a plurality of sputtering targets (5) spaced around the walls of the chamber, each sputtering target having electrode means associated therewith; and means for altering the position of the substrate support table relative to each one of the plurality of sputtering targets (4) such that in use a substrate placed on the substrate support table may have a film deposited thereon of atoms sputtered from at least one of the said plurality of targets and subsequently, following alteration of the position of the substrate support table, have at least one further film deposited thereon by exposure to atoms form at least one other of said plurality of targets. A method of depositing multi-layer materials on a substrate and a method of controlling stoichiometry of deposited alloys are also provided.

## Description

The present invention relates to vacuum sputtering apparatus. More particularly, it relates to a vacuum sputtering apparatus for deposition of multi-layers of thin films of sputtered material onto a substrate. The present invention also relates to a novel method of effecting vacuum sputtering to form multi-layer thin films on a substrate and a novel method of controlling stoichiometry in films formed from alloys.

Although various techniques have been suggested for the production of thin films, vacuum sputtering methods are generally preferred as they offer various advantages. In particular, a stronger adhesive force between the film and the substrate may be noted when vacuum sputtering techniques are used to lay down the film than has been achievable heretofore. Similarly, stronger adhesive forces between layers in a multi-layer system are noted.

In general, vacuum sputtering is a technique in which a target is bombarded with ions generated in a plasma such that clusters of atoms of the target material are ejected from the target and are deposited on a substrate. The chamber in which the sputtering occurs is a vacuum chamber which is typically maintained at a pressure of from about 10 Pa to about 10⁻² Pa. The lower limit is dictated by the collapse of the sheath due to insufficient ionisation. In practice, the chamber will generally be evacuated to high vacuum and then back filled to the appropriate pressure with a noble gas such as argon, krypton or xenon. In some arrangements 'reactive operation' may be used in which gases such as oxygen or nitrogen may be added to the noble gas flow such that the oxides or nitrides of the metal can be deposited.

Suitable substrates includes silicon wafers, ceramic, plastics, metals or glass. This technique enables thin films, such as those having a thickness as low as about 0.5 nm, to be formed. However, generally the thickness of the coating laid down will be selected to be appropriate to the application to which the finished article will be put.

For some optical applications such as the fabrication of low loss laser mirrors and/or dense wavelength division multiplexers, it is necessary to deposit several layers such that a multi-layer structure is obtained. In the applications detailed above it is also important that each layer is laid down with precision in order to achieve the required level of performance.

The ability to lay down multi-layer thin films with precision is also important in the production of thin film magnetic sensors such as those used in hard disk drives and in Magneto-resistive Random Access Memory (MRAM). These specialised devices are generally either "spin-value" devices, which are based upon the Giant Magneto Resistance (GMR) effect, or "tunnel junction" devices. Each layer of these multi-layer structures may be comprised of a different material, each of which provides a required property to the finished product. For example, such devices may comprise an underlayer, which promotes the crystal orientation of upper layers, magnetic layers and spacer layers.

In general, the magnitude of the GMR effect will depend upon the thickness of these magnetic and spacer layers and the performance of the device will depend on the interlayer interfaces.

It is therefore important that the technique used to construct these multi-layer thin film structures is reproducible and precise to ensure that each item of the device produced has the required level of performance.

It has been noted that the time delay which occurs between the completion of the deposition of one layer onto the substrate and the commencement of the deposition of the next layer has an effect on the quality of the interlayer interfaces. This time delay is known as "latency". Latency in excess of about 30 secs can result in detrimental effects to the interlayer interfaces.

For ease of manufacturing, techniques are currently used in which each layer is deposited on the substrate in discrete chambers. Whilst this method is successful in the semiconductor field, it has not proved successful in the production of magnetic structures such as hard disk drives and MRAM. This is due to the number of different materials required to lay down the various layers such that several discrete chambers are required which means that the level of latency between each layer being laid down is unacceptably high.

With a view to attempting to overcome this problem, proposals have been made for mounting a plurality of deposition targets on a single chamber in such a way as to be able to deposit multiple layers onto a substrate mounted on a substrate support table. However, due to the size of these arrangements, it is difficult to mount sufficient targets onto the chamber. Further, even if it is possible to do so, the number mounted is restricted and the footprint of the overall apparatus is generally too large. The throughput is also restricted.

Whilst several attempts have been made to produce systems which have the capability of producing multi-layer materials in which the latency between the deposition of each layer is minimised, whilst some have achieved a reduction in latency, this has been at the expense of throughput and the resultant apparatus has had a large footprint.

Thus, whilst an arrangement in which discrete chambers are used but are located close together goes some way to reduce the latency problem, the throughput of product is generally low, making the procedure costly.

An additional drawback of this type of arrangement is that the apparatus and the associated equipment has a large footprint. The size of the apparatus is significant since it has an impact on the costs of operating the system due to the clean room floor area needed to accommodate the discrete chambers and the associated handling equipment.

The present invention solves the problems associated with prior art devices by the provision of improved vacuum sputtering apparatus that is capable of reproducibly depositing multi-layer materials with minimum latency and maximum precision. A further advantage of the apparatus is that the footprint is minimised.

Thus, according to a first aspect of the present invention, there is provided a vacuum sputtering apparatus capable of depositing a plurality of thin film layers on a substrate, the apparatus comprising:
(a) a vacuum chamber having gas inlet means and gas evacuation means;
(b) a substrate support table arranged to be rotatable about at least one axis perpendicular to the plane of the table;
(c) means for rotating the substrate support table about said at least one axis;
(d) a plurality of sputtering targets spaced around the walls of the chamber, each sputtering target having electrode means associated therewith; and
(e) means for altering the position of the substrate support table relative to each one of the plurality of sputtering targets such that in use a substrate placed on the substrate support table may have a film deposited thereon of atoms sputtered from at least one of the said plurality of targets and subsequently, following alteration of the position of the substrate support table, have at least one further film deposited thereon by exposure to atoms form at least one other of said plurality of targets.

Thus, where the chamber includes several targets with the associated electrodes, the substrate support table may be oriented such that the substrate faces each in turn such that sputtering of each layer can occur. Where two or more layers are to be formed from the same material, the apparatus may include two or more targets of the same material. However, more preferably there will be a single target and the substrate support table's orientation will return to the position for the single target on each occasion that a layer of the specific material is required.

The present invention therefore provides apparatus whereby multi-layers of thin films can be formed on the substrate and in which the latency is minimised. Further, the overall footprint of the apparatus is substantially less than has been achievable heretofore.

The relative position of the substrate to the sputtering targets and associated electrodes may be altered in any suitable manner. Whilst in one arrangement the substrate support table may be moved longitudinally within the chamber so that deposition can occur from targets and electrodes located on one wall of the vacuum chamber, in a preferred arrangement, the targets and electrodes are located on more than one wall of the vacuum chamber. In this arrangement, the relative movement of the support table is a rotation about an axis orthogonal to the axis of rotation of the support.

In a preferred arrangement, the vacuum chamber is rhombohedron and one or more targets and associated electrodes are located on each of a plurality of faces. In a most preferred arrangement the vacuum chamber is cuboid and one or more targets and associated electrodes are located on a plurality of faces, most preferably, on each face.

Any number of target and electrode arrangements may be present limited only by the size and geometry of the vacuum chamber. In one embodiment, six or eight target and electrode arrangements may be present. In another embodiment, ten or twelve target and electrode arrangements may be present.

The means for altering the relative position of the support table may be any suitable means but preferably allows the substrate support table to be turned through 360° about the at least one axis and most preferably allows that the support table may be turned to face any point within the vacuum chamber.

A services enclosure is preferably located on the side of the substrate support table remote from that which is used to support the substrate. This services enclosure may include the means by which the relative position of the substrate support table is altered. The means may be motor powered by any suitable means.

The apparatus may include means for introducing the substrate into the vacuum chamber. Most preferably the apparatus includes a vacuum load lock having a letter box type gate valve through which the substrate may be introduced into the vacuum chamber and loaded onto the substrate support table.

Any suitable target and associated electrode arrangement may be used. In one arrangement, each target will generally be held on a water cooled backing plate which is connected to an electrical power supply which may be rf or dc. The backing plate is in contact with the electrodes which, where the power source is rf, may be rf diodes or rf magnetrons and where the power source is dc, are generally dc magnetrons. For examples of suitable electrode assemblies reference may be made to EP-A-0261922 and GB-A-1482632 which are incorporated herein by reference.

Any suitable target material may be used. In one arrangement, each target may be comprised of an antiferromagnetic material, a high moment magnetic material, a moderate moment magnetic material, a non-magnetic material, a dielectric material or a ceramic material. Examples of antiferromagnetic materials used as target material include FeMn, IrMn or PtMn. Examples of high moment magnetic materials include Ni₅₅Fe₄₅, FeX and Fe. Examples of moderate moment magnetic materials include Ni₈₁Fe₁₉. Examples of non-magnetic materials include Cu, Ta, Ru and Al. Examples of dielectric materials include SiO₂, Ta₂O₅, Titania, Hafnia and Zirconia.

The position of the substrate support table may mean that there is a long throw between the target from which the atoms are to be sputtered and the substrate. In one alternative arrangement, telescopic targets and electrodes may be used such that the gap may be reduced. In another alternative arrangement, the substrate support table may be adjustable in height.

Where required, each target and electrode arrangement is provided with protection to prevent line of sight deposition from another electrode.

In one arrangement, shutters may be used. Thus, in use, the shutter is opened for the target and associated electrodes from which deposition is to occur and the shutter on the remaining electrodes remain closed. When the substrate support table's position is adjusted such that deposition can occur from a different target and associated electrodes, the shutter on the first target will be closed and that on the newly selected target will open. The movement and opening and closing of the shutters will generally be automated.

Any suitable shutter arrangement may be used. However, "dustbin lid style" shutters on helical drives are particularly preferred. By "dustbin lid style" shutters we mean disc shutters with a peripheral lip orthogonal to the plane of the disc and facing the target. This arrangement allows the shutter to lift as it turns. This allows discharge to be operated while the shutter is closed for pre-cleaning the target material.

In an alternative arrangement, each electrode and target is located behind an isolation gate valve. This type of arrangement is advantageous as it allows the timing for the deposition to be minimised since the time required to operate the physical shutter is removed. Whilst a mechanical shutter will generally still be required to prevent cross contamination, the combination of mechanical and electrical systems is particularly advantageous.

In particular, for very thin layers with short deposition times the traverse of a shutter can lead to degradation in either side-to-side or, in the case of on-axis wafer rotation, azimuthal uniformity. This problem can be addressed-in one embodiment by the use of a mechanical shutter for cross-contamination control and the use of electrostatic shuttering for process control.

Thus, in a preferred embodiment of the present invention, the following sequence may be used. With the mechanical shutter closed the glow discharge which will affect a specific material deposition will be ignited (typically this would be initiated before the previous film deposition was completed). The discharge may be briefly "burned" to pre-clean the target. The power to the electrode driving the glow discharge will then be interrupted, the mechanical shutter opened and the discharge turned on by turning on the power supply. This turning on would typically be synchronised with a specific position of the substrate on the table. On completion of the deposition, the process will be terminated, by turning off the power supply, again in a synchronous fashion. Once the discharge has been extinguished, the mechanical shutter is closed to guard against cross-contamination from other materials being deposited within the apparatus.

In one arrangement, one or more of the target and electrode arrangements may be replaced by an ion beam source such as that described in WO 98/18150 which is incorporated herein by reference. Ion beam systems have a typical operating pressure range of from about 0.1 to about 10¹³ Pa.

According to a second aspect of the present invention, there is provided a method of depositing multi-layer materials on a substrate by vacuum sputtering comprising:
(a) providing a substrate on a substrate support table which is rotatable about at least one axis perpendicular to the plane of the substrate and which is located within a vacuum chamber;
(b) introducing gas at a suitable pressure into the chamber;
(c) providing a plurality of targets each having electrode means associated therewith spaced around the vacuum chamber;
(d) orientating the substrate support table such that it is in an appropriate orientation for deposition to occur from at least one of said targets and associated electrodes;
(e) causing the substrate support table to rotate;
(f) providing power to said electrodes associated with said at least one target such that the gas forms a plasma and the ions therefrom cause atoms to be sputtered from the at least one target and deposited onto the substrate to form a first layer;
(g) removing power from the said electrodes;
(h) adjusting the orientation of the substrate support table such that deposition can occur from at least one other of said targets and associated electrodes;
(i) applying power to said electrodes associated with said other target such that a further layer is formed on the previous layer; and
(j) repeating steps (h) and (i) as required.

It will be understood that at each change in orientation, the substrate support table may be turned such that deposition can occur from one or more targets which have not previously been used to form a layer on the substrate or where a further layer of a material used for an earlier layer is to be deposited, the table may revert to an orientation already used.

The table may be orientated such that it is parallel to the target from which deposition is to occur or such that it is at an angle thereto. Carrying out the deposition with the table at an angle has particular advantages with regard to the thin film non-uniformity. In conventional apparatus it is possible to offset the axis of the substrate support table from the axis of the electrode to provide angled deposition. However, the planes of the substrate and the electrode are generally parallel. With the arrangement of the present invention, this type of offset can be achieved by appropriate location of the targets and associated electrode means. However, in addition, the angle of the planes can be inclined by means of an arrangement where the target is located axially above the support table but the table is tilted relative to the plane of the target. In an alternative arrangement a combination of offset and tilt may be used to reduce the offset necessary to achieve the desired degree of non-uniformity. The conventional arrangement will generally give in the region of ± 2% non-uniformity in a metal film on a 200mm wafer. Whereas inclining the angle and having only a small offset of the substrate and electrode can give a non-uniformity of the order of ± 0.2%. Angular offset is typically in the range of from about 10° to about 30° from parallel but can be larger and offset is typically in the region of about 50 to about 100 mm.

As previously discussed, in conventional apparatus it is possible to offset the axis of the substrate support table from the axis of the electrode to provide angled deposition which has advantages with regard to thin film non-uniformity. In the embodiment of the present invention in which the angled deposition may be provided either by offset or inclination or by both offset and inclination, a further benefit can be achieved where the material to be deposited is a binary alloy. Traditionally, such alloys are provided from a target made from the alloy. However, whilst the target may have the required stoichiometry problems are noted in achieving the desired stoichiometry in the deposited film and in obtaining repeatable results in a manufacturing system. In general, the composition of the deposited film will not be the same as that of the target and will not have the correct phase such that it must be annealed for several hours before it can be tested. In addition, the composition will vary with deposition pressure and target ageing.

The arrangements of the present invention allows for the binary alloy to be formed in situ on the substrate by providing a target of each of the components of the alloy and allowing deposition to occur simultaneously from these. In one arrangement these targets and corresponding electrodes are located on adjacent faces of the chamber and the support table is positioned so that deposition can occur from both in an inclined manner. The ability to alter the inclination will enable the homogenised ratio of components to be altered such that the composition can be carefully controlled. This allows for a wider tolerance on the target composition to be achieved than has been available heretofore and also enables the problems associated with ageing of the target to be compensated. Since the support table is rotating, the composition is homogenised about the point of deposition. The composition may be adjusted by varying the relative power of the electrodes associated with the targets.

In an alternative arrangement the support table may face more than two electrodes such that higher alloys such as tertiary or quaternary alloys may be deposited.

Thus, according to a third aspect of the present invention there is provided a method of controlling the stoichiometry of deposited alloys on a substrate by vacuum sputtering comprising:
(a) providing a substrate on a substrate on a substrate support table which is rotatable about at least on axis perpendicular to the plane of the substrate and which is located within a vacuum chamber;
(b) introducing gas at a suitable pressure into the chamber;
(c) providing a plurality of targets each having electrodes means associated therewith spaced around the vacuum chamber;
(d) orientating the substrate support table such that it is in an appropriate orientation for deposition to occur from two or more of said targets and associated electrodes;
(e) causing the substrate support table to rotate; and
(f) providing power to said electrodes associated with said two or more targets such that the gas forms a plasma and causes atoms to be sputtered from the two or more targets and deposited onto the substrate to form an alloy on the substrate.

The stoichiometry of the alloy may be adjusted by altering the inclination of the substrate support table and/or the relative power to the electrode means associated with the two or more targets.

The change in orientation of the substrate support table is preferably a rotation which may be about one or more axis.

The gas admitted to the chamber may be any suitable gas but is preferably a noble gas such as argon, krypton or xenon.

Any suitable operating conditions may be utilised. Pressures in the region of from about 10⁻¹ Pa to about 5 x 10⁻² Pa are particularly preferred. Gas flows in the region of about 5 to about 20 seem are particularly advantageous as are rotation speeds in the region of from about 30 rpm to about 60 rpm but speeds up to about 1000 rpm may be useful in some specific applications.

The present invention enables a significant reduction in latency with time delays of the order of 10 to 5 seconds or less being achievable. Further, the smaller footprint of the apparatus offers significant cost advantages. In addition, improvements in throughput can be noted. In particular the compactness of the overall module may allow several such modules to be utilised in a standard style cluster configuration which will additionally improve throughput.

A preferred example of the present invention will now be described with reference to the accompanying drawings in which:
- Figure 1: is a schematic diagram of apparatus in accordance with the present invention;
- Figure 2: is a copy of Figure 1 illustrating one direction of movement of the substrate support table;
- Figure 3: is a schematic diagram of one alternate arrangement for the arrangement of targets and associated electrodes; and
- Figure 4: is a schematic diagram of a further arrangement in which a bank of four electrodes are located on a face of the chamber.

All references made herein to specific orientation (eg top, bottom, front and back) are made for the purpose of describing relative spatial arrangements of the features of the apparatus and are not intended to be limiting. It will be understood that the figures are merely schematic and that further items of equipment such as vacuum pumps, control valves, pressure sensors, flux shapers and the like may be required in a commercial vacuum sputtering apparatus. further items of equipment such as vacuum pumps, control valves, pressure sensors, flux shapers and the like may be required in a commercial vacuum sputtering apparatus.

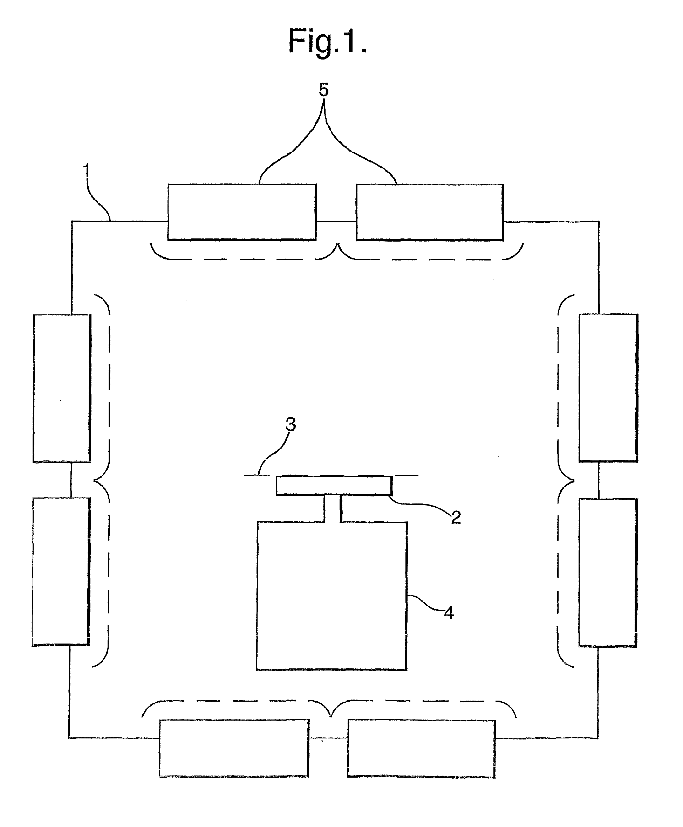

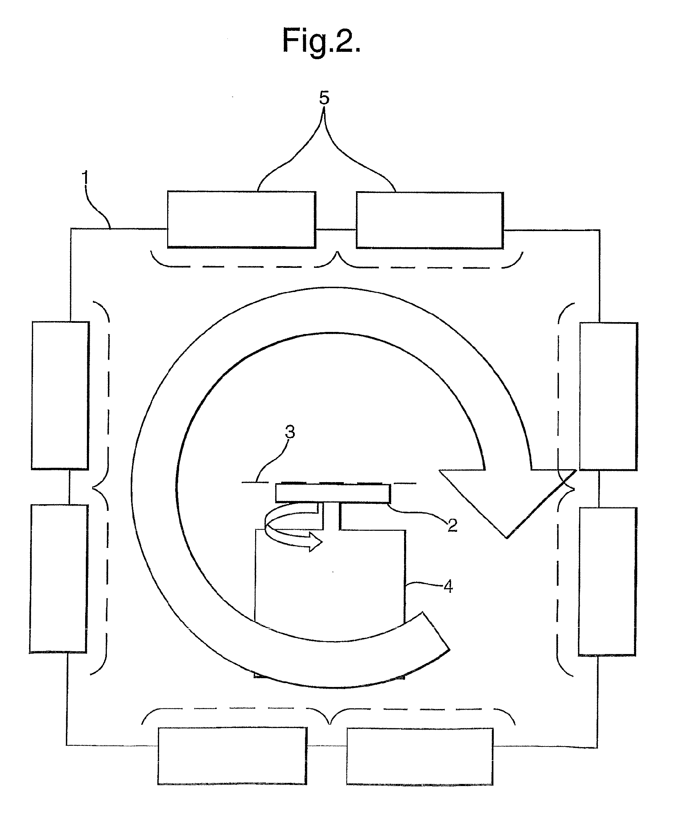

As show in Figure 1, the vacuum sputtering apparatus of the present invention comprises a vacuum chamber 1 containing a substrate support table 2 on which a substrate 3 may be placed. The table 2 is connected to a table services enclosure 4 and, as illustrated by arrow A in Figure 2, is rotatable about an axis orthogonal to the plane of the table. The motor for driving the rotation is located within the enclosure 4.

Mounted on the wall of the chamber 1 are electrode and target arrangements 5 which operate by conventional means.

The table 2 can, as illustrated by arrow B in Figure 2, be turned to face or to be at an angle to, one or more of the electrodes. The angle will be from about 10 to 30°.

The vacuum chamber 1 may include a vacuum load lock so that a substrate 3 can be placed upon the rotatable substrate table, for example by a robotic arm, while maintaining the vacuum conditions within vacuum chamber 1.

Alternatively, vacuum chamber 1 may not include a vacuum load lock, in which case the vacuum conditions in the chamber will be lost each time a new substrate 3 is placed on substrate table 2. In this mode of operation the substrate is placed on the substrate table 2 manually and then the vacuum chamber 1 is evacuated.

Vacuum chamber 1 is evacuated and maintained at a pressure in the range of from about 10⁻⁵ millibar (about 10⁻⁴ Pa) to about 10⁻³ millibar (about 10⁻² Pa).

As power is applied to the electrode/target arrangement to which the table is pointed, a plasma is formed in the chamber and ions from said plasma impact the target and cause atoms of the deposition material to be sputtered and deposited onto the rotating substrate resulting in a thin film of material on the substrate to be formed.

With minimal time delay (of the order of five seconds or less) the table can then be turned to face the next electrode/target arrangement such that a second layer is deposited.

This process is repeated until the desired multi-layer structure is completed.

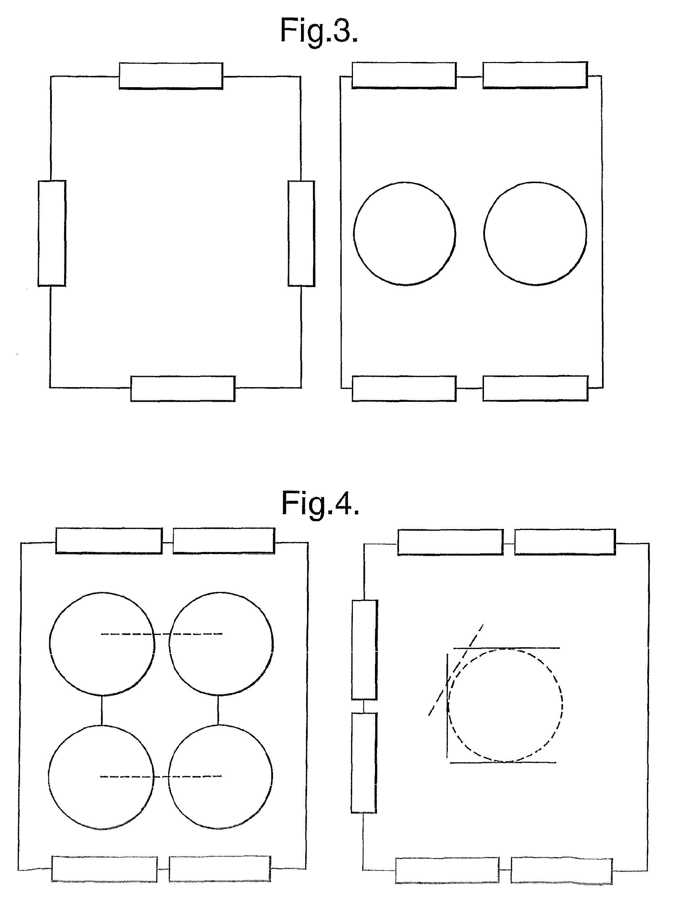

Where the substrate table has only one axis of rotation, the targets and associated electrodes may be located in the path of rotation as illustrated in Figure 1 or, as illustrated in Figure 3, may be located offset the path of rotation

In one arrangement, the targets and associated electrodes may be located in pairs spaced across the path of rotation of the table. These may be used to allow separate deposition of the components of a binary alloy such that the alloy is formed in situ on the surface of the substrate. By this means, the stoichiometry of the alloy may be carefully controlled.

For example, where the substrate is to be coated with a PtMn layer as is often required as an antiferromagnetic material in a magnetic sensor, the ratio of Pt to Mn is desirably 50:50. By depositing the platinum and manganese from separate targets the problems associated with ageing etc can be readily overcome and the stoichiometry of the deposited film can be carefully controlled. Further, the ability to incline the substrate table provides two further opportunities. As the inclination is changed there is a change in the homogenised platinum to manganese ratio in the deposited film. This is generally not a large change being of the order of about 1 to about 2wt%. However, it is significant change in a manufacturing process as generally in prior art arrangements, the window for composition control is usually at most 1wt%. The ability to control this provides a wider tolerance on the composition and enables manufacturers to deal with the ageing of the target.

In addition, since the aspect of the two adjacent electrodes illustrated in Figure 3 is symmetric with respect to the substrate, it is possible to deposit one component from one electrode and the other from the second electrode in such a manner that the composition is homogenised by rotation of the substrate via rotation of the support table.

In an alternative arrangement, a bank of four targets with associated electrodes may be located on the faces of the chamber. In one arrangement this will allow twelve targets to be utilised within a compact space. This arrangement is particularly useful for the production of higher alloys such as tertiary or even quaternary alloys such as CrSiXY. This is beneficial as it allows high alloy composition control in the deposition of thin layers such as those required for precision resistors of the kind used in A to D and D to A converters.

### Clauses

1. A vacuum sputtering apparatus capable of depositing a plurality of thin film layers on a substrate, the apparatus comprising:
   (a) a vacuum chamber having gas inlet means and gas evacuation means;
   (b) a substrate support table arranged to be rotatable about at least one axis perpendicular to the plane of the table;
   (c) means for rotating the substrate support table about said at least one axis;
   (d) a plurality of sputtering targets spaced around the walls of the chamber, each sputtering target having electrode means associated therewith; and
   (e) means for altering the position of the substrate support table relative to each one of the plurality of sputtering targets such that in use a substrate placed on the substrate support table may have a film deposited thereon of atoms sputtered from at least one of the said plurality of targets and subsequently, following alteration of the position of the substrate support table, have at least one further film deposited thereon by exposure to atoms form at least one other of said plurality of targets.
2. A vacuum sputtering apparatus according Clause 1 wherein the plurality of targets is of different material.
3. A vacuum sputtering apparatus according to Clause 1 or 2 wherein the substrate support table is moved longitudically within the vacuum chamber.
4. A vacuum sputtering apparatus according to Clause 1 or 2 wherein the targets are located on more than one wall of the vacuum chamber.
5. A vacuum sputtering apparatus according to Clause 4 wherein the vacuum chamber is rhombodedron and one or more targets are located on each of a plurality of faces.
6. A vacuum sputtering apparatus according to Clause 5 wherein the vacuum chamber is cuboid and one or more targets are located on a plurality of faces.
7. A vacuum sputtering apparatus according to any one of Clauses 4 to 6 wherein the substrate support table is rotated about an axis orthogonal to the axis of rotation of the support.
8. A vacuum sputtering apparatus according to Clause 7 wherein the rotation is through 360°C.
9. A vacuum sputtering apparatus according to any one of Clauses 1 to 8 wherein the apparatus includes means for introducing the substrate into the vacuum chamber.
10. A vacuum sputtering apparatus according to any one of Clauses 1 to 9 wherein the electrode and target arrangement may be telescopic.
11. A vacuum sputtering apparatus according to any one of Clauses 1 to 10 wherein each target and electrode arrangement is provided with protection to prevent line of sight deposition from another electrode.
12. A vacuum sputtering apparatus according to Clause 11 wherein the protection is provided by a shutter.
13. A vacuum sputtering apparatus according to Clause 12 wherein at least one of the shutters is a dustbin lid style shutter on a helical drive.
14. A vacuum sputtering apparatus according to Clause 11 wherein the protection is provided by locating each electrode and target behind an isolation gate valve.
15. A method of depositing multi-layer materials on a substrate by vacuum sputtering comprising:
   (a) providing a substrate on a substrate support table which is rotatable about at least one axis perpendicular to the plane of the substrate and which is located within a vacuum chamber;
   (b) introducing gas at a suitable pressure into the chamber;
   (c) providing a plurality of targets each having electrode means associated therewith spaced around the vacuum chamber;
   (d) orientating the substrate support table such that it is in an appropriate orientation for deposition to occur from at least one of said targets and associated electrodes;
   (e) causing the substrate support table to rotate;
   (f) providing power to said electrodes associated with said at least one target such that the gas forms a plasma and the ions therefrom cause atoms to be sputtered from the at least one target and deposited onto the substrate to form a first layer;
   (g) removing power from the said electrodes;
   (h) adjusting the orientation of the substrate support table such that deposition can occur from at least one other of said targets and associated electrodes;
   (i) applying power to said electrodes associated with said other target such that a further layer is formed on the previous layer; and
   (j) repeating steps (h) and (i) as required.
16. A method according to Clause 15 wherein the table may be orientated such that it is parallel to the electrode/target arrangement or such that it is an angle thereto.
17. A method according to Cl use 15 or 16 wherein the change in orientation of the substrate support table is a rotation.
18. A method of controlling the stoichiometry of deposited alloys on a substrate by vacuum sputtering comprising:
   (a) providing a substrate on a substrate on a substrate support table which is rotatable about at least on axis perpendicular to the plane of the substrate and which is located within a vacuum chamber;
   (b) introducing gas at a suitable pressure into the chamber;
   (c) providing a plurality of targets each having electrodes means associated therewith spaced around the vacuum chamber;
   (d) orientating the substrate support table such that it is in an appropriate orientation for deposition to occur from two or more of said targets and associated electrodes;
   (e) causing the substrate support table to rotate; and
   (f) providing power to said electrodes associated with said two or more targets such that the gas forms a plasma and causes atoms to be sputtered from the two or more targets and deposited onto the substrate to form an alloy on the substrate.
19. A method according to Clause 18 wherein the stoichiometry is adjusted by adjusting the inclination of the substrate support table and/or the relative power to the electrodes associated with each of the targets.

## Claims

**1.** A vacuum sputtering apparatus capable of depositing a plurality of thin film layers on a substrate, the apparatus comprising:
(a) a vacuum chamber having gas inlet means and gas evacuation means;
(b) a substrate support table arranged to be rotatable about at least one axis perpendicular to the plane of the table;
(c) means for rotating the substrate support table about said at least one axis;
(d) a plurality of sputtering targets spaced around the walls of the chamber, each sputtering target having electrode means associated therewith;
(e) means for altering the position of the substrate support table relative to each one of the plurality of sputtering targets such that in use a substrate placed on the substrate support table may have a film deposited thereon of atoms sputtered from at least two of the said plurality of targets and subsequently, following alteration of the position of the substrate support table, have at least one further film deposited thereon by exposure to atoms at least one other of said plurality of targets; and
(f) wherein each said target and associated electrode means arrangement is provided with a respected shutter to prevent line of sight deposition from another electrode.

**2.** A vacuum sputtering apparatus according to Claim 1 wherein the plurality of targets is of different material.

**3.** A vacuum sputtering apparatus according to Claim 1 or 2 wherein the substrate support table is moved longitudically within the vacuum chamber.

**4.** A vacuum sputtering apparatus according to Claim 1 or 2 wherein the targets are located on more than one wall of the vacuum chamber.

**5.** A vacuum sputtering apparatus according to Claim 4 wherein the vacuum chamber is rhombodedron and one or more targets are located on each of a plurality of faces.

**6.** A vacuum sputtering apparatus according to Claim 5 wherein the vacuum chamber is cuboid and one or more targets are located on a plurality of faces.

**7.** A vacuum sputtering apparatus according to any one of Claims 4 to 6 wherein the substrate support table is rotated about an axis orthogonal to the axis of rotation of the support.

**8.** A vacuum sputtering apparatus according to Claim 7 wherein the rotation is through 360°C.

**9.** A vacuum sputtering apparatus according to any one of Claims 1 to 8 wherein the apparatus includes means for introducing the substrate into the vacuum chamber.

**10.** A vacuum sputtering apparatus according to any one of Claims 1 to 9 wherein the electrode and target arrangement may be telescopic.

**11.** A vacuum sputtering apparatus according to any one of Claims 1 to 10 wherein at least one of the shutters is a dustbin lid style shutter on a helical drive.

**12.** A method of depositing multi-layer materials on a substrate by vacuum sputtering comprising:
(a) providing a substrate on a substrate support table which is rotatable about at least one axis perpendicular to the plane of the substrate and which is located within a vacuum chamber;
(b) introducing gas at a suitable pressure into the chamber;
(c) providing a plurality of targets each having electrode means associated therewith spaced around the vacuum chamber, wherein each said target and associated electrode means is provided with a respective shutter to prevent line of sight deposition from another electrode;
(d) orientating the substrate support table such that it is in an appropriate orientation for deposition to occur from at least two of said targets and associated electrodes;
(e) causing the substrate support table to rotate;
(f) removing said respective shutters from said at least two targets and associated electrode means from which deposition is to occur;
(g) providing power to said electrodes associated with said at least two targets such that the gas forms a plasma and the ions therefrom cause atoms to be sputtered from the at least two targets and deposited onto the substrate to form a first layer;
(h) removing power from the said electrodes;
(i) replacing said respective shutters on said at least two targets and electrode arrangements from which deposition has occurred;
(j) adjusting the orientation of the substrate support table such that deposition can occur from at least one other of said targets and associated electrodes;
(k) removing said respective shutter from said at least one other of said target and associated electrode means from which deposition is to occur;
(l) applying power to said electrodes associated with said other target such that a further layer is formed on the previous layer;
(m) replacing said respective shutter on said at least one other target and electrode arrangement from which deposition has occurred;
(n) repeating steps (j) and (m) as required.

**16.** A method according to Claim 15 wherein the table may be orientated such that it is parallel to the electrode/target arrangement or such that it is an angle thereto.

**17.** A method according to Claim 15 or 16 wherein the change in orientation of the substrate support table is a rotation.

**18.** A method of controlling the stoichiometry of deposited alloys on a substrate by vacuum sputtering comprising:
(a) providing a substrate on a substrate on a substrate support table which is rotatable about at least on axis perpendicular to the plane of the substrate and which is located within a vacuum chamber;
(b) introducing gas at a suitable pressure into the chamber;
(c) providing a plurality of targets each having electrodes means associated therewith spaced around the vacuum chamber;
(d) orientating the substrate support table such that it is in an appropriate orientation for deposition to occur from two or more of said targets and associated electrodes wherein each said target and associated electrode means is provided with a respective shutter to prevent line of sight deposition from another electrode;
(e) causing the substrate support table to rotate;
(f) removing said respective shutter from two or more of said targets and associated electrode means from which deposition is to occur; and
(g) providing power to said electrodes associated with said two or more targets such that the gas forms a plasma and causes atoms to be sputtered from the two or more targets and deposited onto the substrate to form an alloy on the substrate.

**19.** A method according to Claim 18 wherein the stoichiometry is adjusted by adjusting the inclination of the substrate support table and/or the relative power to the electrodes associated with each of the targets.
